# EUROPEAN PATENT APPLICATION

(11) **EP 4 764 562 A1**
(43) Date of publication of application: **24.06.2026**
(21) Application number: 25782862.4
(22) Date of filing: 06.02.2025
(51) Int. Cl.: G01R 31/396, G01R 31/382, G01R 31/367, G01R 19/00, G01R 19/10

(54) **BATTERY DIAGNOSIS DEVICE AND OPERATING METHOD THEREOF**

(30) Priority: 05.04.2024 KR 20240046861
(71) Applicant: LG Energy Solution, Ltd., Seoul 07335 (KR)
(72) Inventor: KIM, Young Min, Daejeon 34122 (KR)
(74) Representative: Plasseraud IP
(86) International application number: PCT/KR2025/001775
(87) International publication number: WO 2025/211557

(57) **Abstract**

A battery diagnosis device according to an embodiment disclosed in this document may include an interface that acquires open circuit voltage (OCV) data of a battery cell and one or more processors that calculate an OCV deviation representing a difference between an average OCV corresponding to a specific point in time and an OCV of a battery cell for each of a plurality of battery cells included in a specific battery module based on the OCV data, acquire a plurality of OCV moving averages by applying different weighted moving averages to the OCV deviation, and diagnose an abnormality of the battery cell based on the plurality of OCV moving averages.

## Description

### TECHNICAL FIELD

### Cross-reference to Related Applications

This application claims priority from Korean Patent Application No. 10-2024-0046861, filed on April 5, 2024, the disclosures of which are incorporated by reference herein.

### Technical Field

Embodiments disclosed in this document relate to a battery diagnosis device and an operating method thereof.

### BACKGROUND ART

Recently, research and development on secondary batteries have been actively conducted. Here, secondary batteries are batteries that may be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

In addition, the secondary batteries may generally be used as a battery pack that includes battery modules in each of which a plurality of battery cells are connected in series and/or in parallel. Also, the secondary batteries may be used as a battery rack that include a plurality of battery modules and a rack frame that accommodate these battery modules.

Such battery cells, battery modules, battery packs, or battery racks may be utilized in various devices. For example, batteries may be utilized in mobile devices such as mobile phones, laptop computers, smart phones, and smart pads, but also in the field of electric vehicles (EVs, HEVs, PHEVs) and large-capacity power storage devices (ESS).

The state and operation of these batteries may be managed and controlled by a battery management system (BMS). The battery management system may be included together with a battery within a single device.

In addition, the battery management system may manage and control the battery while being separated from a device including the battery. For example, the battery management system may be implemented as a separate server device. In this case, the battery management system may collect battery data and vehicle data from vehicles, etc., and manage and control the battery using the collected data.

### DISCLOSURE OF THE INVENTION

### TECHNICAL PROBLEM

When a short circuit or other type of failure occurs inside a battery, the possibility of damage to devices including the battery (e.g., EV and ESS) may increase. Accordingly, a method for detecting an abnormal state of the battery and reducing the possibility of damage to devices including the battery is required.

Conventionally, diagnosis of a battery cell was performed by a calculation method using all of the information of state of charge (SOC), current, capacity, and open circuit voltage (OCV). Since this diagnosis method has to utilize many factors, there was a problem that diagnosis was difficult when specific information among the above information was missing. This may highlight a problem in a battery management system implemented as a server device that should collect data from a vehicle, and may cause a problem of excessively high memory usage. Accordingly, simplification of data required for battery diagnosis is required.

The embodiments disclosed in this document may provide a battery diagnosis device and an operating method thereof that may diagnose an abnormality of a battery using only battery OCV data information.

The technical problems of the embodiments disclosed in this document are not limited to the technical problems mentioned above, and other technical problems not mentioned will be clearly understood by those skilled in the art from the descriptions below.

### TECHNICAL SOLUTION

A battery diagnosis device according to an embodiment disclosed in this document may include an interface that acquires open circuit voltage (OCV) data of a battery cell and one or more processors that calculate an OCV deviation representing a difference between an average OCV corresponding to a specific point in time and an OCV of a battery cell for each of a plurality of battery cells included in a specific battery module based on the OCV data, acquire a plurality of OCV moving averages by applying different weighted moving averages to the OCV deviation, and diagnose an abnormality of the battery cell based on the plurality of OCV moving averages.

In the battery diagnosis device according to an embodiment disclosed in this document, the one or more processors may acquire the plurality of OCV moving averages by applying the different weighted moving averages to a plurality of past OCV moving averages corresponding to past points in time before the specific point in time and the OCV deviation corresponding to the specific point in time.

In the battery diagnosis device according to an embodiment disclosed in this document, the one or more processors may acquire a first OCV moving average by applying a first weighted moving average to a first past OCV moving average among the plurality of past OCV moving averages and the OCV deviation, acquire a second OCV moving average by applying a second weighted moving average to a second past OCV moving average among the plurality of past OCV moving averages and the OCV deviation, and diagnose the abnormality of the battery cell based on the first OCV moving average and the second OCV moving average.

In the battery diagnosis device according to an embodiment disclosed in this document, the first weighted moving average may be applied to the first past OCV moving average and the OCV deviation, and a 1_1-th weighted moving average weight applied to the OCV deviation may be greater than a 1_2-th weighted moving average weight applied to the first past OCV moving average, and the second weighted moving average may be applied to the second past OCV moving average and the OCV deviation, and a 2_1-th weighted moving average weight applied to the OCV deviation may be less than a 2_2-th weighted moving average weight applied to the second past OCV moving average.

In the battery diagnosis device according to an embodiment disclosed in this document, the one or more processors may calculate an OCV moving average deviation representing a difference between the plurality of OCV moving averages, acquire an OCV evaluation value by applying a preset weight to the OCV moving average deviation, and diagnose the abnormality of the battery cell based on the OCV evaluation value.

In the battery diagnosis device according to an embodiment disclosed in this document, the one or more processors may acquire the OCV evaluation value by applying the preset weight to a past OCV evaluation value corresponding to a past point in time before the specific point in time and the OCV moving average deviation corresponding to the specific point in time.

In the battery diagnosis device according to an embodiment disclosed in this document, among the preset weights, a first weight applied to the OCV moving average deviation may be less than a second weight applied to the past OCV evaluation value.

In the battery diagnosis device according to an embodiment disclosed in this document, the one or more processors may set a threshold OCV evaluation value corresponding to the specific battery module, and diagnose the abnormality of the battery cell based on the OCV evaluation value and the threshold OCV evaluation value.

A battery diagnosis method according to an embodiment disclosed in this document may include an operation of acquiring open circuit voltage (OCV) data of a battery cell, an operation of calculating an OCV deviation representing a difference between an average OCV corresponding to a specific point in time and an OCV of a battery cell for each of a plurality of battery cells included in a specific battery module based on the OCV data, an operation of acquiring a plurality of OCV moving averages by applying different weighted moving averages to the OCV deviation, and an operation of diagnosing an abnormality of the battery cell based on the plurality of OCV moving averages.

In the battery diagnosis method according to an embodiment disclosed in this document, the operation of acquiring the plurality of OCV moving averages may include an operation of acquiring the plurality of OCV moving averages by applying the different weighted moving averages to a plurality of past OCV moving averages corresponding to past points in time before the specific point in time and the OCV deviation corresponding to the specific point in time.

In the battery diagnosis method according to an embodiment disclosed in this document, the operation of acquiring the plurality of OCV moving averages may include an operation of acquiring a first OCV moving average by applying a first weighted moving average to a first past OCV moving average among the plurality of past OCV moving averages and the OCV deviation, and an operation of acquiring a second OCV moving average by applying a second weighted moving average to a second past OCV moving average among the plurality of past OCV moving averages and the OCV deviation, and the operation of diagnosing the abnormality of the battery cell may include an operation of diagnosing the abnormality of the battery cell based on the first OCV moving average and the second OCV moving average.

In the battery diagnosis method according to an embodiment disclosed in this document, a 1_1-th weighted moving average weight applied to the OCV deviation may be greater than a 1_2-th weighted moving average weight applied to the first past OCV moving average, and a 2_1-th weighted moving average weight applied to the OCV deviation may be less than a 2_2-th weighted moving average weight applied to the second past OCV moving average.

In the battery diagnosis method according to an embodiment disclosed in this document, the operation of diagnosing the abnormality of the battery cell may include an operation of calculating an OCV moving average deviation representing a difference between the plurality of OCV moving averages, an operation of acquiring an OCV evaluation value by applying a preset weight to the OCV moving average deviation, and an operation of diagnosing the abnormality of the battery cell based on the OCV evaluation value.

In the battery diagnosis method according to an embodiment disclosed in this document, the operation of diagnosing the abnormality of the battery cell may include an operation of acquiring the OCV evaluation value by applying the preset weight to a past OCV evaluation value corresponding to a past point in time before the specific point in time and the OCV moving average deviation corresponding to the specific point in time.

In the battery diagnosis method according to an embodiment disclosed in this document, among the preset weights, a first weight applied to the OCV moving average deviation may be less than a second weight applied to the past OCV evaluation value.

The battery diagnosis method according to an embodiment disclosed in this document may further include an operation of setting a threshold OCV evaluation value corresponding to the specific battery module, and the operation of diagnosing the abnormality of the battery cell may include an operation of diagnosing the abnormality of the battery cell based on the OCV evaluation value and the threshold OCV evaluation value.

### ADVANTAGEOUS EFFECTS

According to the embodiments disclosed in this document, data used for diagnosing the abnormality of the battery can be simplified.

According to the embodiments disclosed in this document, the accuracy of battery abnormality diagnosis may be improved by diagnosing the abnormality of the battery based on a plurality of OCV moving averages acquired by applying different weighted moving averages to OCV deviations.

In addition, various effects can be provided that are directly or indirectly identified through this document.

### BRIEF DESCRIPTION OF THE DRAWINGS

FIG. 1 is a block diagram of a battery diagnosis device according to an embodiment.
FIG. 2 is a diagram for describing an embodiment in which a battery diagnosis device diagnoses an abnormality of a battery cell.
FIG. 3a to FIG. 3d are diagrams for describing an embodiment in which a battery diagnosis device diagnoses an abnormality of a battery cell.
FIG. 4 is an operation flowchart of a battery diagnosis device according to an embodiment.
FIG. 5 illustrates a computing system that executes an operating method of a battery diagnosis device according to an embodiment.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

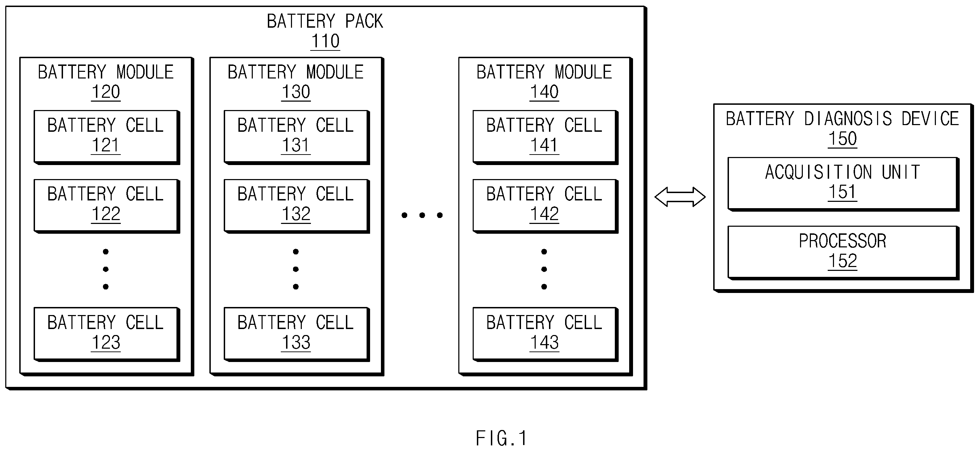

FIG. 1 is a block diagram of a battery diagnosis device according to an embodiment.

Referring to FIG. 1, a battery pack 110 may include a plurality of battery modules 120, 130, and 140, and each of the plurality of battery modules 120, 130, 140 may include a plurality of battery cells 121, 122, 123, 131, 132, 133, 141, 142, and 143. According to an embodiment, the battery pack 110 may be a battery mounted inside an electric vehicle to provide power to the electric vehicle.

According to an embodiment, a battery diagnosis device 150 may diagnose an abnormality of a battery unit based on OCV data acquired from the battery unit. In the present disclosure, the battery unit may mean the battery pack 110, the battery module 120, 130, or 140, or the battery cell 121, 122, 123, 131, 132, 133, 141, 142, or 143.

According to an embodiment, the battery diagnosis device 150 may be formed integrally with the battery unit. In this case, the battery diagnosis device 150 may be included in a battery management system (BMS) of the battery unit.

According to an embodiment, the battery diagnosis device 150 may be formed separately from the battery unit. In this case, the battery diagnosis device 150 may be implemented as an external server connected to the battery unit through a wireless network.

In addition, an operation of the battery diagnosis device 150 below may be performed by the battery management system (BMS) in the vehicle, and may also be performed by various devices such as a server, cloud, charger, or charger/discharger.

According to an embodiment, the battery diagnosis device 150 may include an interface 151, and one or more processors 152.

According to an embodiment, the interface 151 may acquire OCV data of the battery cells 121, 122, 123, 131, 132, 133, 141, 142, and/or 143. For example, the interface 151 may acquire information about voltage, current, and/or temperature of the battery cells 121, 122, 123, 131, 132, 133, 141, 142, and/or 143 and construct OCV data based on the acquired information. In this case, the interface 151 may include a sensor for acquiring information about the voltage, current, and/or temperature and a processor for constructing the OCV data based on the acquired information. As another example, the interface 151 may receive the OCV data of the battery cells 121, 122, 123, 131, 132, 133, 141, 142, and/or 143 acquired by the battery unit. In this case, the interface 151 may include a communication circuit capable of wired and/or wireless network communication.

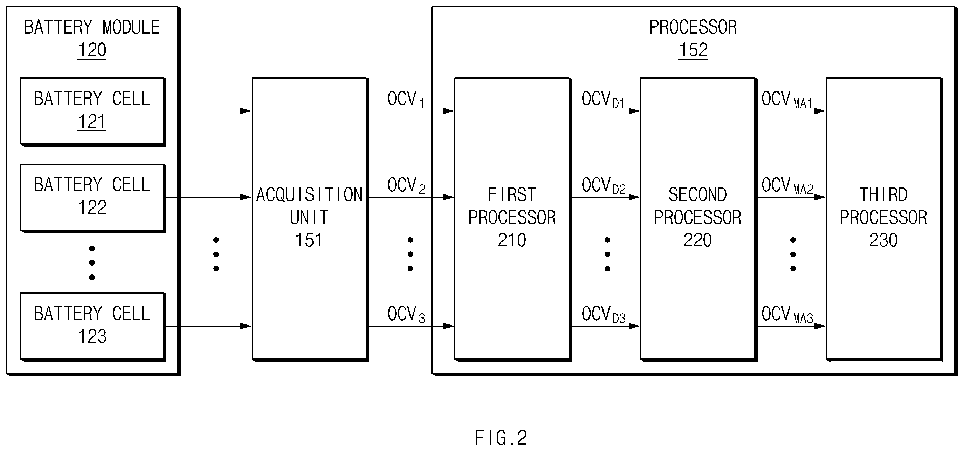

According to an embodiment, the processor 152 may calculate a determination value (e.g., OCV deviation, OCV moving average, OCV moving average deviation, and/or OCV evaluation value) based on the OCV data acquired by the interface 151. According to an embodiment, the processor 152 may extract OCV data of a specified voltage range from the OCV data. The processor 152 may calculate a determination value based on the extracted OCV data of the specified voltage range. Various embodiments in which the processor 152 calculates the determination value may be specifically described in FIGS. 2 to 3d to be described below.

According to an embodiment, the processor 152 may diagnose an abnormality of the battery unit based on the calculated determination value.

According to an embodiment, the processor 152 may diagnose the abnormality of the battery unit by comparing the determination value with a threshold value corresponding thereto. For example, the processor 152 may diagnose the battery unit (e.g., the battery cell 121, 122, 123, 131, 132, 133, 141, 142, and/or 143) as an abnormal battery unit when the determination value (e.g., the OCV evaluation value) is less than or equal to a threshold value (e.g., -3mV).

The processor 152 described above may be implemented as one processor or as separate processors. Here, the processor may execute software to control at least one other component (e.g., hardware or software component) of the battery diagnosis device 150 and perform various data processing or computations.

According to an embodiment, the battery diagnosis device 150 may transmit a battery diagnosis result to an external source (e.g., a cloud server or a user terminal). Here, the cloud server may provide a service for providing the battery diagnosis result to each of a plurality of users. In addition, the user terminal may include a terminal such as a personal computer (PC) or a smartphone. As an example, the battery diagnosis device 150 may provide information about an abnormal battery cell to the user terminal through a communication unit (not illustrated), and may also provide information about an abnormal battery cell through a display.

Hereinafter, various embodiments in which the processor 152 diagnoses an abnormality of a battery unit will be described with reference to FIGS. 2 to 3d. FIGS. 2 to 3d may be described using the components of FIG. 1 (e.g., the interface 151 and the processor 152).

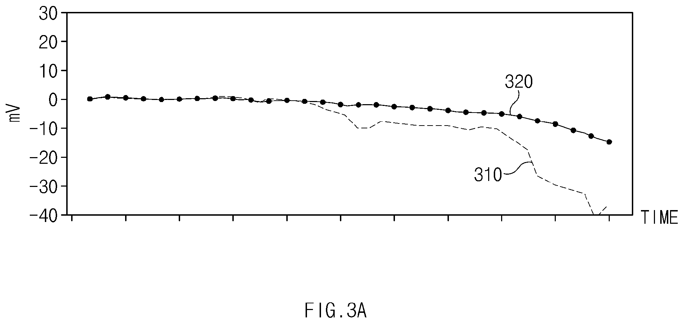

FIG. 2 is a diagram for describing an embodiment in which a battery diagnosis device calculates a determination value. FIG. 3a to 3d are diagrams for describing an embodiment in which the battery diagnosis device diagnoses an abnormality of a battery cell.

Referring to FIG. 2, the processor 152 may include a first processor 210, a second processor 220, and a third processor 230.

According to an embodiment, the interface 151 may transmit OCV data of a plurality of battery cells included in a plurality of battery modules to the first processor. For example, the interface 151 may transmit OCV data OCV₁, OCV₂, and OCV₃ of a plurality of battery cells 121, 122, and 123 of a specific battery module 120 to the first processor 210. For reference, for convenience of description, one battery module 120 will be described as an example below, but the number of battery modules is not limited thereto.

According to an embodiment, the first processor 210 may calculate OCV deviations OCV_{D1}, OCV_{D2}, and OCV_{D3}, which represent a difference between an average OCV corresponding to a specific point in time and the OCV OCV₁, OCV₂, and OCV₃ of the battery cell 121, 122, and 123 for each of the plurality of battery cells 121, 122, and 123 included in the specific battery module 120, based on the OCV data OCV₁, OCV₂, and OCV₃. For example, the first processor 210 may calculate the OCV deviation OCV_{D1} indicating the difference between an average OCV (e.g., (OCV₁+OCV₂+OCV₃/3) corresponding to a specific point in time of the plurality of battery cells 121, 122, and 123 included in the specific battery module 120 and the OCV OCV₁ corresponding to the specific point in time of the battery cell 121.

According to an embodiment, the first processor 210 may transmit the calculated OCV deviations OCV_{D1}, OCV_{D2}, and OCV_{D3} to the second processor 220.

According to an embodiment, the second processor 220 may acquire a plurality of OCV moving averages OCV_{MA1}, OCV_{MA2}, and OCV_{MA3} for each of the plurality of battery cells 121, 122, and 123 by applying different weighted moving averages to the OCV deviations OCV_{D1}, OCV_{D2}, and OCV_{D3}. Here, each of the plurality of OCV moving averages OCV_{MA1}, OCV_{MA2}, and OCV_{MA3} may correspond to each of the plurality of battery cells 121, 122, and 123. For example, the second processor 220 may acquire the plurality of OCV moving averages OCV_{MA1} corresponding to the battery cell 121 by applying different weighted moving averages OCV_{MA1} to the OCV deviation OCV_{D1}.

According to an embodiment, the second processor 220 may acquire the plurality of OCV moving averages OCV_{MA1}, OCV_{MA2}, and OCV_{MA3} by applying different weighted moving averages to a plurality of past OCV moving averages corresponding to past points in time before a specific point in time and the OCV deviations OCV_{D1}, OCV_{D2}, OCV_{D3} corresponding to the specific point in time. For example, the second processor 220 may acquire the plurality of OCV moving averages OCV_{MA1} by applying the different weighted moving averages to the plurality of past OCV moving averages corresponding to past points in time before a specific point in time and a plurality of OCV deviations OCV_{MA1} corresponding to the specific point in time. Here, the past points in time before the specific point in time may be points in time immediately before the specific point in time, but this is only an example and is not limited thereto.

According to an embodiment, the second processor 220 may acquire a first OCV moving average OCV_{MA1}, OCV_{MA2} and/or OCV_{MA3} by applying a first weighted moving average to a first past OCV moving average among the plurality of past OCV moving averages and the OCV deviation OCV_{D1}, OCV_{D2} and/or OCV_{D3}. In addition, the second processor 220 may acquire a second OCV moving average OCV_{MA1}, OCV_{MA2} and/or OCV_{MA3} by applying a second weighted moving average to a second past OCV moving average among the plurality of past OCV moving averages and the OCV deviation OCV_{D1}, OCV_{D2} and/or OCV_{D3}. Here, the method by which the first past OCV moving average and the second past OCV moving average corresponding to a past point in time are acquired is similar to the method by which the first OCV moving average and the second OCV moving average OCV_{MA1}, OCV_{MA2} and/or OCV_{MA3} corresponding to a specific point in time are acquired, and thus a duplicate description thereof will be omitted.

For example, the second processor 220 may acquire the first OCV moving average OCV_{MA1} by applying the first weighted moving average to the first past OCV moving average among the plurality of past OCV moving averages and the OCV deviation OCV_{D1}. In addition, the second processor 220 may acquire the second OCV moving average OCV_{MA1} by applying the second weighted moving average, which is different from the first weighted moving average, to the second past OCV moving average among the plurality of past OCV moving averages and the OCV deviation OCV_{D1}.

According to an embodiment, in applying the first weighted moving average to the first past OCV moving average and the OCV deviation by the second processor 220, a 1_1-th weighted moving average weight applied to the OCV deviation may be greater than a 1_2-th weighted moving average weight applied to the first past OCV moving average. In addition, in applying the second weighted moving average to the second past OCV moving average and the OCV deviation by the second processor 220, a 2_1 weighted moving average weight applied to the OCV deviation may be less than a 2_2 weighted moving average weight applied to the second past OCV moving average.

For example, the second processor 220 may acquire the first OCV moving average OCV_{MA1} by applying the 1_1 weighted moving average weight (e.g., 0.95) to the OCV deviation OCV_{D1} and applying a 1_2 weighted moving average weight (e.g., 0.05) to the first past OCV moving average among the weights (0.95 and 0.05) of the first weighted moving average, and then adding up the results of these applications. For example, the second processor 220 may acquire the second OCV moving average OCV_{MA1} by applying a 2_1 weighted moving average weight (e.g., 0.05) to the OCV deviation OCV_{D1} and applying a 2_2 weighted moving average weight (e.g., 0.95) to the second past OCV moving average among the weights (0.09 and 0.95) of the second weighted moving average, and then adding up the results of these applications. Here, 0.95 and 0.05 are only examples of weighted moving average weight values, and are not limited thereto.

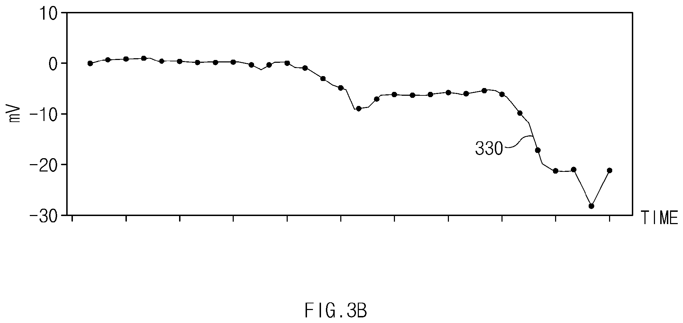

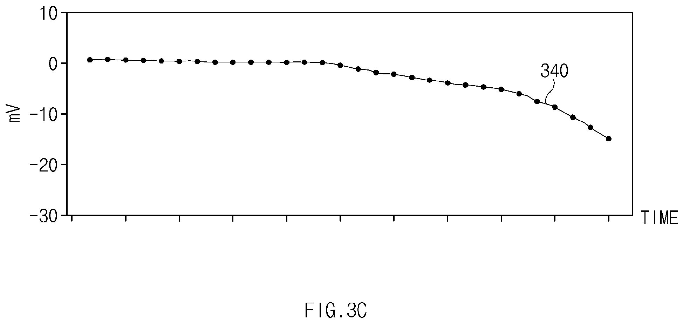

Referring to FIG. 3a, a first OCV moving average 310 and a second OCV moving average 310 corresponding to a plurality of points in time may be confirmed. For reference, FIG. 3a and FIGS. 3b and 3c described below illustrate that the OCV deviation at a regular periodic interval is calculated based on OCV data acquired at regular intervals (e.g., 10 days), illustrate the OCV moving average, OCV moving average deviation, and OCV evaluation value acquired based on this OCV deviation, in which the horizontal axis represents time (days), one division of the horizontal axis corresponds to one month, and the vertical axis represents voltage (mV).

According to the example, in the case of the first OCV moving average, since the weight (e.g., 1_1 weighted moving average weight) applied to the OCV deviation is greater than the weight (e.g., 1_2 weighted moving average weight) applied to the first past OCV moving average, the value of the first OCV moving average is greatly affected by the value of the OCV deviation corresponding to the current point in time (a specific point in time). Therefore, it may be confirmed that the larger the OCV deviation calculated based on OCV data acquired at a specific point in time, the more rapidly the value of the first OCV moving average 310 changes, as illustrated in FIG. 3a.

On the other hand, in the case of the second OCV moving average, since the weight (e.g., 2_2 weighted moving average weight) applied to the second past OCV moving average is greater than the weight (e.g., 2_1 weighted moving average weight) applied to the OCV deviation, the value of the second OCV moving average is less affected by the value of the OCV deviation corresponding to the current point in time (a specific point in time). Therefore, even if the OCV deviation calculated based on the OCV data acquired at a specific point in time is large, as illustrated in FIG. 3a, it can be confirmed that the value of the second OCV moving average 320 changes relatively gradually.

According to an embodiment, the second processor 220 may transmit the generated first OCV moving averages OCV_{MA1}, OCV_{MA2} and/or OCV_{MA3} and the second OCV moving averages OCV_{MA1}, OCV_{MA2} and/or OCV_{MA3} to the third processor 230.

According to an embodiment, the third processor 230 may diagnose an abnormality of the battery cells 121, 122 and/or 123 based on the first OCV moving averages OCV_{MA1}, OCV_{MA2} and/or OCV_{MA3} and the second OCV moving averages OCV_{MA1}, OCV_{MA2} and/or OCV_{MA3}. For example, the third processor 230 may diagnose an abnormality of the battery cell 121 based on the first OCV moving average OCV_{MA1} and the second OCV moving average OCV_{MA1}.

According to an embodiment, the third processor 230 may calculate an OCV moving average deviation representing a difference between a plurality of OCV moving averages. For example, the third processor 230 may calculate an OCV moving average deviation representing a difference between a plurality of OCV moving averages (the first OCV moving average OCV_{MA1} and the second OCV moving average OCV_{MA1}) corresponding to the battery cell 121.

Referring to FIG. 3b, the OCV moving average deviation 330 representing the difference between the first OCV moving average 310 and the second OCV moving average 320 illustrated in FIG. 3a can be confirmed.

According to an embodiment, the third processor 230 may calculate an OCV evaluation value by applying an evaluation weight set to the calculated OCV moving average deviation.

According to an embodiment, the third processor 230 may acquire the OCV evaluation value by applying the preset weight to the past OCV evaluation value corresponding to a past point in time before a specific point in time and the OCV moving average deviation corresponding to the specific point in time.

According to an embodiment, among preset weights, a first weight applied to the OCV moving average deviation may be less than a second weight applied to the past OCV evaluation value. For example, the third processor 230 may acquire an OCV evaluation value by applying a first weight of 0.2 to the OCV moving average deviation corresponding to the battery cell 121 and applying a second weight of 0.8 to the past OCV evaluation value corresponding to the battery cell 121 among the preset weights of 0.2 and 0.8, and then adding up the results of these applications.

Referring to FIG. 3c, the OCV evaluation value 340 acquired based on the OCV moving average deviation 330 illustrated in FIG. 3b can be confirmed.

Specifically, since the preset weight (e.g., the second weight) applied to the past OCV evaluation value corresponding to the past time point is greater than the preset weight (e.g., the first weight) applied to the OCV moving average deviation 330 corresponding to a specific time point, it can be confirmed that even if the OCV moving average deviation 330 changes rapidly at the specific time point, the OCV evaluation value changes relatively gradually. Accordingly, an over-diagnosis rate can be reduced in diagnosing abnormalities in the battery cells 121, 122, 123, 131, 132, 133, 141, 142, and/or 143 based on comparison with a threshold OCV evaluation value described below.

According to an embodiment, the third processor 230 may diagnose an abnormality of a battery cell based on the acquired OCV evaluation value.

According to an embodiment, the third processor 230 may set a threshold OCV evaluation value corresponding to a specific battery module 120 and diagnose an abnormality of the battery cells 121, 122, and/or 123 based on the OCV evaluation value and the threshold OCV evaluation value.

For example, the third processor 230 may set a threshold OCV evaluation value (e.g., -3 mV) corresponding to the specific battery module 120 and diagnose the abnormality of the battery cell 121 based on the OCV evaluation value (e.g., -3 mV) of the battery cell 121 and the threshold OCV evaluation value. For example, the third processor 230 may diagnose that there is an abnormality in the battery cell 121 when the OCV evaluation value of the battery cell 121 is less than or equal to the threshold OCV evaluation value.

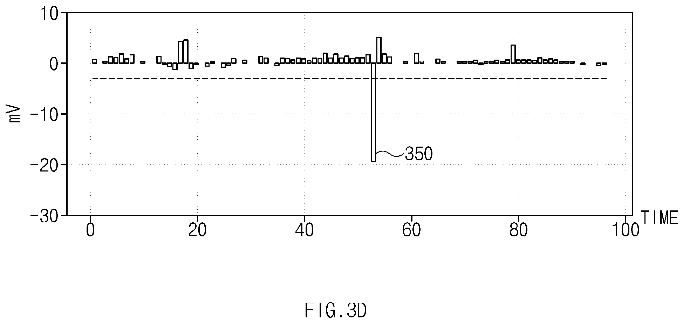

FIG. 3d illustrates OCV evaluation values for a plurality of battery cells.

Referring to FIG. 3d, it can be confirmed that the OCV evaluation value 350 corresponding to a specific point in time of a k-th battery cell among a plurality of battery cells is -24.12 mV, which is less than the threshold OCV evaluation value of -3 mV. In this case, the third processor 230 may diagnose that there is a problem in the k-th battery cell.

The first processor 210 to the third processor described above may be implemented as one processor or separate processors. Here, the processor may execute software to control at least one other component (e.g., hardware or software components) of the battery diagnosis device 150 and perform various data processing or computations.

According to an embodiment, the battery diagnosis device 150 may transmit the battery diagnosis result to an external device (e.g., a cloud server or a user terminal). Here, the cloud server may provide a service for providing battery diagnosis results to each of plurality of users. In addition, the user terminal may include a terminal such as a personal computer (PC) or a smartphone.

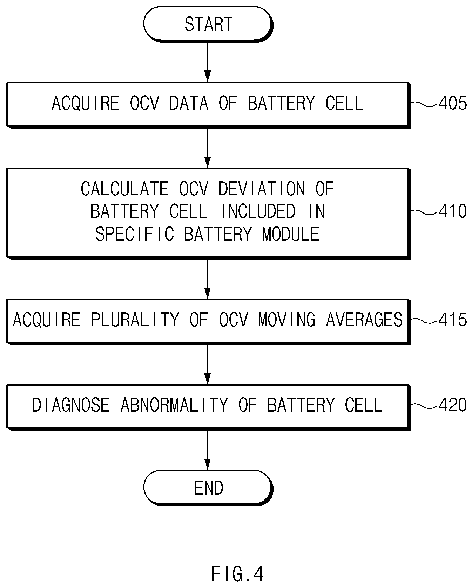

FIG. 4 is an operation flowchart of a battery diagnosis device according to an embodiment. FIG. 4 may be a description of the operation of the battery diagnosis device 150 of FIG. 1, and may be described using the components of FIG. 1.

The embodiment illustrated in FIG. 4 is only an embodiment, and the order of steps according to various embodiments of the present invention may be different from that illustrated in FIG. 4, and some of the steps illustrated in FIG. 4 may be omitted, the order between the steps may be changed, or the steps may be merged.

Referring to FIG. 4, in operation 405, the battery diagnostic device 150 may acquire OCV data of the battery cells 121, 122, 123, 131, 132, 133, 141, 142 and/or 143. For example, the battery diagnostic device 150 may construct OCV data based on voltage, current, and/or temperature measurement information of the battery cells 121, 122, 123, 131, 132, 133, 141, 142, and/or 143. As another example, the battery diagnosis device 150 may receive OCV data of the battery cells 121, 122, 123, 131, 132, 133, 141, 142 and/or 143 acquired by the battery modules 120, 130, and 140 or the battery cells 121, 122, 123, 131, 132, 133, 141, 142 and/or 143.

In operation 410, the battery diagnosis device 150 may calculate an OCV deviation representing a difference between an average OCV corresponding to a specific point in time and an OCV of a battery cell for each of a plurality of battery cells included in a specific battery module based on the OCV data acquired in operation 405. According to an embodiment, the battery diagnosis device 150 may extract OCV data of a designated voltage range (e.g., a voltage range of 3.9 V or higher) from among the OCV data. The battery diagnosis device 150 may calculate the OCV deviation based on the extracted OCV data of the specified voltage range.

In operation 415, the battery diagnosis device 150 may acquire a plurality of OCV moving averages by applying different weighted moving averages to the OCV deviation. Here, the plurality of OCV moving averages may correspond to battery cells. According to an embodiment, the battery diagnosis device 150 may acquire a plurality of OCV moving averages by applying a plurality of weighted moving averages to a plurality of past OCV moving averages corresponding to past points in time before a specific point in time and the OCV deviation. According to an embodiment, the battery diagnosis device 150 may acquire a first OCV moving average by applying a first weighted moving average to a first past OCV moving average among a plurality of past OCV moving averages and the OCV deviation, and a second OCV moving average by applying a second weighted moving average to a second past OCV moving average among a plurality of past OCV moving averages and the OCV deviation. According to an embodiment, a 1_1 weighted moving average weight applied to the OCV deviation may be greater than a 1_2 weighted moving average weight applied to the first past OCV moving average, and a 2_1 weighted moving average weight applied to the OCV deviation may be less than a 2_2 weighted moving average weight applied to the second past OCV moving average.

In operation 420, the battery diagnosis device 150 may diagnose an abnormality of a battery cell based on a plurality of OCV moving averages. According to an embodiment, the battery diagnosis device 150 may diagnose the abnormality of the battery cell based on the first OCV moving average and the second OCV moving average. According to an embodiment, the battery diagnosis device 150 may calculate an OCV moving average deviation representing a difference between a plurality of OCV moving averages, apply a preset weight to the OCV moving average deviation to acquire an OCV evaluation value, and diagnose the abnormality of the battery cell based on the OCV evaluation value. According to an embodiment, the battery diagnosis device 150 may acquire the OCV evaluation value by applying the preset weight to a past OCV evaluation value corresponding to a past point in time before a specific point in time and the OCV moving average deviation. According to an embodiment, among the preset weights, a first weight applied to the OCV moving average deviation may be less than a second weight applied to the past OCV evaluation value. According to an embodiment, the battery diagnosis device 150 may set a threshold OCV evaluation value corresponding to a specific battery module, and may diagnose an abnormality of the battery cell based on the OCV evaluation value and the threshold OCV evaluation value.

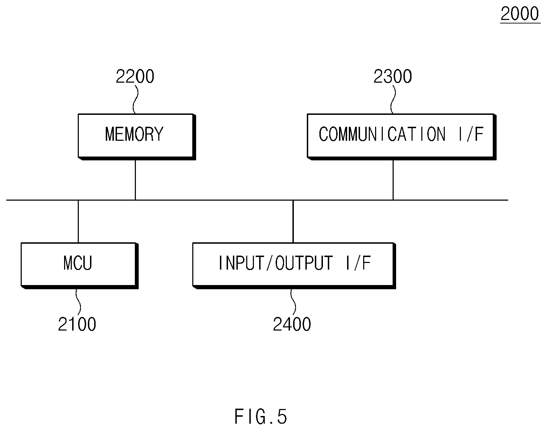

FIG. 5 illustrates a computing system that executes an operating method of a battery diagnosis device according to an embodiment disclosed in this document.

Referring to FIG. 5, a computing system 2000 according to an embodiment disclosed in this document may include an MCU 2100, a memory 2200, a communication I/F 2300, and an input/output I/F 2400.

The MCU 2100 may be a processor that executes various programs (e.g., battery diagnosis programs) stored in the memory 2200 and performs the functions of the battery diagnosis device 150 described with reference to FIG. 1 and FIG. 2 described above, or a processor that executes the operating method of the battery diagnosis device described with reference to FIG. 4.

The memory 2200 may store various programs related to calculating the SOH of a battery cell and determining a cell balancing target, a battery connection failure determination program, a battery data transmission program, a battery diagnosis program, etc. In addition, the memory 2200 may store various data such as SOC, SOH data, a sensing value, and a temperature of each battery cell.

A plurality of these memories 2200 may be provided as needed. The memory 2200 may be a volatile memory or a nonvolatile memory. The memory 2200 as a volatile memory may be RAM, DRAM, SRAM, etc. The memory 22100 as a non-volatile memory may be ROM, PROM, EAROM, EPROM, EEPROM, flash memory, etc. The examples of the memories 2200 listed above are merely examples and are not limited to these examples.

The input/output I/F 2400 may provide an interface that allows data to be transmitted and received between input devices (not illustrated) such as a keyboard, mouse, and touch panel and output devices (not illustrated) such as a display and the MCU 2100.

The communication I/F 2300 is a component that may transmit and receive various data to and from a server, and may be various devices that may support wired or wireless communication. For example, a program for calculating the SOH of the battery cell or determining a balancing target, various data, a battery data transmission program, a battery diagnosis program, etc. may be transmitted to and received from a separately provided external server through the communication I/F 2300.

In this way, the operating method of the battery management device according to an embodiment disclosed in this document may be recorded in the memory 2200 and executed by the MCU 2100.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

## Claims

1. A battery diagnosis device comprising:
an interface that acquires open circuit voltage (OCV) data of a battery cell; and
one or more processors that calculate an OCV deviation representing a difference between an average OCV corresponding to a specific point in time and an OCV of a battery cell for each of a plurality of battery cells included in a specific battery module based on the OCV data, acquire a plurality of OCV moving averages by applying different weighted moving averages to the OCV deviation, and diagnose an abnormality of the battery cell based on the plurality of OCV moving averages.

2. The battery diagnosis device of claim 1, wherein the one or more processors acquire the plurality of OCV moving averages by applying the different weighted moving averages to a plurality of past OCV moving averages corresponding to past points in time before the specific point in time and the OCV deviation corresponding to the specific point in time.

3. The battery diagnosis device of claim 2, wherein the one or more processors acquire a first OCV moving average by applying a first weighted moving average to a first past OCV moving average among the plurality of past OCV moving averages and the OCV deviation, acquire a second OCV moving average by applying a second weighted moving average to a second past OCV moving average among the plurality of past OCV moving averages and the OCV deviation, and diagnose the abnormality of the battery cell based on the first OCV moving average and the second OCV moving average.

4. The battery diagnosis device of claim 3, wherein the one or more processors
apply the first weighted moving average to the first past OCV moving average and the OCV deviation, and a 1_1-th weighted moving average weight applied to the OCV deviation is greater than a 1_2-th weighted moving average weight applied to the first past OCV moving average, and
apply the second weighted moving average to the second past OCV moving average and the OCV deviation, and a 2_1-th weighted moving average weight applied to the OCV deviation is less than a 2_2-th weighted moving average weight applied to the second past OCV moving average.

5. The battery diagnosis device of claim 1, wherein the one or more processors calculate an OCV moving average deviation representing a difference between the plurality of OCV moving averages, acquire an OCV evaluation value by applying a preset weight to the OCV moving average deviation, and diagnose the abnormality of the battery cell based on the OCV evaluation value.

6. The battery diagnosis device of claim 5, wherein the one or more processors acquire the OCV evaluation value by applying the preset weight to a past OCV evaluation value corresponding to a past point in time before the specific point in time and the OCV moving average deviation corresponding to the specific point in time.

7. The battery diagnosis device of claim 6, wherein, among the preset weights, a first weight applied to the OCV moving average deviation is less than a second weight applied to the past OCV evaluation value.

8. The battery diagnosis device of claim 5, wherein the one or more processors set a threshold OCV evaluation value corresponding to the specific battery module, and diagnose the abnormality of the battery cell based on the OCV evaluation value and the threshold OCV evaluation value.

9. An operating method of a battery diagnosis device, comprising:
an operation of acquiring open circuit voltage (OCV) data of a battery cell;
an operation of calculating an OCV deviation representing a difference between an average OCV corresponding to a specific point in time and an OCV of a battery cell for each of a plurality of battery cells included in a specific battery module based on the OCV data;
an operation of acquiring a plurality of OCV moving averages by applying different weighted moving averages to the OCV deviation; and
an operation of diagnosing an abnormality of the battery cell based on the plurality of OCV moving averages.

10. The operating method of claim 9, wherein the operation of acquiring the plurality of OCV moving averages includes an operation of acquiring the plurality of OCV moving averages by applying the different weighted moving averages to a plurality of past OCV moving averages corresponding to past points in time before the specific point in time and the OCV deviation corresponding to the specific point in time.

11. The operating method of claim 10, wherein the operation of acquiring the plurality of OCV moving averages includes:
an operation of acquiring a first OCV moving average by applying a first weighted moving average to a first past OCV moving average among the plurality of past OCV moving averages and the OCV deviation; and
an operation of acquiring a second OCV moving average by applying a second weighted moving average to a second past OCV moving average among the plurality of past OCV moving averages and the OCV deviation, and
the operation of diagnosing the abnormality of the battery cell includes an operation of diagnosing the abnormality of the battery cell based on the first OCV moving average and the second OCV moving average.

12. The operating method of claim 11, wherein a 1_1-th weighted moving average weight applied to the OCV deviation is greater than a 1_2-th weighted moving average weight applied to the first past OCV moving average, and
a 2_1-th weighted moving average weight applied to the OCV deviation is less than a 2_2-th weighted moving average weight applied to the second past OCV moving average.

13. The operating method of claim 9, wherein the operation of diagnosing the abnormality of the battery cell include:
an operation of calculating an OCV moving average deviation representing a difference between the plurality of OCV moving averages;
an operation of acquiring an OCV evaluation value by applying a preset weight to the OCV moving average deviation; and
an operation of diagnosing the abnormality of the battery cell based on the OCV evaluation value.

14. The operating method of claim 13, wherein the operation of diagnosing the abnormality of the battery cell includes an operation of acquiring the OCV evaluation value by applying the preset weight to a past OCV evaluation value corresponding to a past point in time before the specific point in time and the OCV moving average deviation corresponding to the specific point in time.

15. The operating method of claim 14, wherein, among the preset weights, a first weight applied to the OCV moving average deviation is less than a second weight applied to the past OCV evaluation value.

16. The operating method of claim 13, further comprising: an operation of setting a threshold OCV evaluation value corresponding to the specific battery module,
wherein, the operation of diagnosing the abnormality of the battery cell includes an operation of diagnosing the abnormality of the battery cell based on the OCV evaluation value and the threshold OCV evaluation value.
